(19) Europäisches Patentamt
European Patent Office
Office européen des brevets

(11) **EP 1 188 228 B1**

(12) **EUROPÄISCHE PATENTSCHRIFT**

(45) Veröffentlichungstag und Bekanntmachung des Hinweises auf die Patenterteilung:
**12.05.2004  Patentblatt 2004/20**

(21) Anmeldenummer: 00943656.9

(22) Anmeldetag: **30.05.2000**

(51) Int Cl.⁷: $H03B\ 21/02$

(86) Internationale Anmeldenummer:
**PCT/DE2000/001759**

(87) Internationale Veröffentlichungsnummer:
**WO 2001/001562 (04.01.2001 Gazette 2001/01)**

(54) **ELEKTRONISCHE SCHALTUNGSANORDNUNG ZUR ERZEUGUNG EINER SENDEFREQUENZ**

ELECTRONIC CIRCUIT ARRANGEMENT GENERATING A TRANSMIT FREQUENCY

CIRCUIT ELECTRONIQUE PERMETTANT DE PRODUIRE UNE FREQUENCE D'EMISSION

(84) Benannte Vertragsstaaten:
**DE ES FR GB IT NL**

(30) Priorität: **24.06.1999  DE 19928998**

(43) Veröffentlichungstag der Anmeldung:
**20.03.2002  Patentblatt 2002/12**

(73) Patentinhaber: **SIEMENS AKTIENGESELLSCHAFT**
**80333 München (DE)**

(72) Erfinder:
 • DETERING, Volker
  **46446 Emmerich (DE)**
 • HEINEN, Stefan
  **47802 Krefeld (DE)**

(56) Entgegenhaltungen:
**US-A- 4 105 949       US-A- 5 179 359**

**Beschreibung**

Die Erfindung betrifft eine elektronische Schaltungsanordnung zur Erzeugung einer Sendefrequenz für einen Sender/Empfänger.

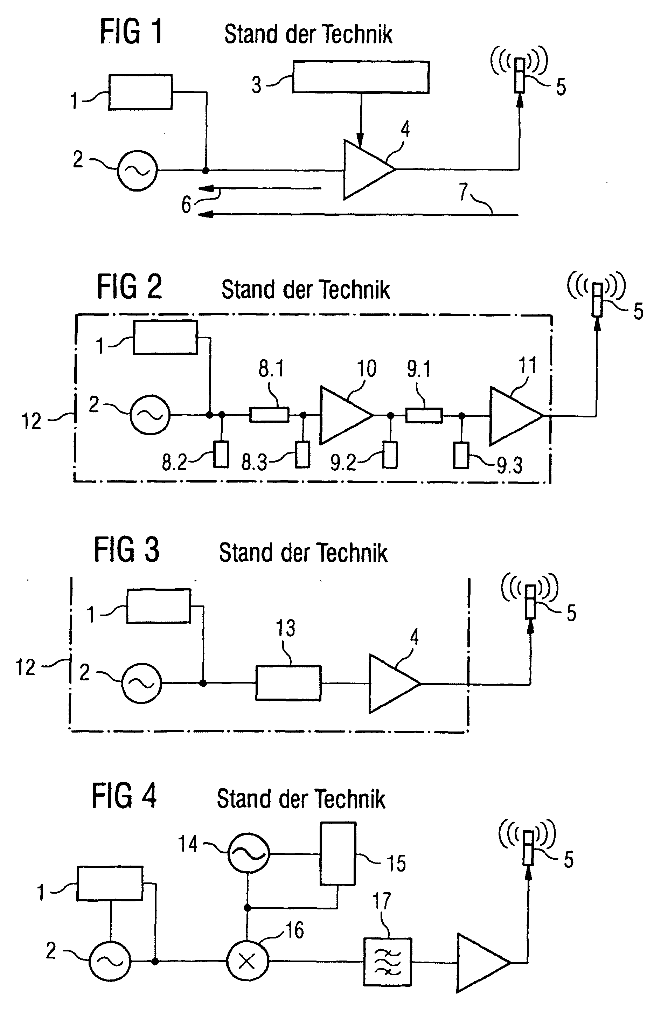

Den Erfindern sind aus dem Stand der Technik ähnliche Schaltungsanordnungen bekannt, um in einem TDMA-Funksystem (zum Beispiel DECT, GSM, PHS) entsprechende Sendefrequenzen zu erzeugen. Die Abkürzung TDMA steht für "Time Division Multiple Access". Eine derartige Anordnung besteht aus einem Oszillator zur Frequenzerzeugung, einem Sendeverstärker, einem Empfänger und einer Steuervorrichtung, welche die zeitliche Abfolge von wechselseitigem Sende- und Empfangszustand bestimmt. Im Allgemeinen wird die Oszillatorfrequenz zur Einstellung des Nachrichtenkanals über die Steuervorrichtung mit Hilfe einer PLL (Phasenregelschleife) zeitlich vor dem Einschalten des Senders eingestellt, da für diesen Vorgang aus technischen Gründen eine gewisse Einstellzeit benötigt wird. Die Erfindung bezieht sich auf den Sendefall in einem solchen TDMA-System deren Anordnung in Figur 1 schematisch dargestellt ist.

Das Problem solcher einfachen Schaltungsanordnung besteht darin, daß im Moment des Einschaltens des Sendeverstärkers die Frequenzerzeugung auf Grund eines Lastwechsels im Verstärker oder durch Rückkopplungen gestört wird. Hierdurch wir ein unerwünschter Frequenzsprung erzeugt. Ein solcher Lastwechsel entsteht beispielsweise beim Einschalten des Sendeverstärkers durch die Änderung seiner Eingangsimpedanz. Eine Rückwirkung auf die Frequenzerzeugung kann beispielsweise über eine Einstrahlung von der Antenne, oder durch andere Verkopplungspfade zwischen der Sende-Endstufe und der Frequenzerzeugung, beispielsweise durch die Versorgungsspannung, entstehen.

Insbesondere bei TDMA-Systemen die aus Kostengründen mit einer langsamen PLL-Regelschleife arbeiten, beziehungsweise die Regelschleife für die Dauer der Modulation öffnen, ist dieser Effekt für die Implementierung ein großes Problem, da der Frequenzsprung nicht mehr durch die PLL-Schaltung korrigiert werden kann. Ein Beispiel hierfür stellt die Open-Loop-Modulation eines DECT-Systems dar.

Das obengenannte Problem wird durch verschiedene, den Erfindern bekannte Schaltungsanordnung angegangen. Beispielsweise besteht die Möglichkeit durch eine Einfügung von Dämpfungsgliedern und Isolationsstufen zwischen der Frequenzerzeugung und dem Sendeverstärker eine Verringerung des für die Frequenzerzeugung sichtbaren Lastwechsels zu bewirken. Außerdem können zusätzliche Abschirmungen der Frequenzerzeugung in Form eines faradayschen Käfigs für eine Verminderung der Einstrahlung sorgen. Weiterhin wird an den Leitungen, welche in die Abschirmung führen eine zusätzliche Abblockung gegen elektromagnetische Einstrahlung, beispielsweise durch besonders gestaltete Stecker vorgenommen. Ein Beispiel für eine derartige bekannte Schaltungsvorrichtung ist in der Figur 2 gezeigt.

Bekannt ist weiterhin, daß durch das Einfügen von Frequenzvervielfacherstufen oder Teilerstufen in die Frequenzerzeugung die Rückkopplung und damit der Einfluß auf die Frequenzerzeugung vermindert wird. Hierbei schwingt ein Oszillator auf einer Harmonischen oder Subharmonischen der gewünschten Frequenz, wodurch sich entsprechend dem Vervielfachungsgrad beziehungsweise Teilungsgrad sowohl eine geringe Lastabhängigkeit als auch eine geringere Empfindlichkeit gegen die Einstrahlung von unerwünschten Frequenzen ergibt. Auch diese Schaltung ist schematisch in der Figur 3 dargestellt.

Zur Lösung des obengenannten Problems ist schließlich die relativ aufwendige Verwendung eines Sendemischkonzeptes, wie es in der Figur 4 schematisch dargestellt ist, den Erfindern bekannt.

Bei diesem Sendemischkonzept werden die Frequenzen zweier Oszillatoren in einer Mischstufe gemischt und die gewünschte Frequenz aus den Mischprodukten herausgesiebt. Da die Oszillatoren ein nichtharmonisches Verhältnis zur gewünschten Frequenz haben, ergibt sich ein hohes Maß an Immunität gegen Lastwechsel und Rückwirkungen. Hierdurch verringern sich die Anforderungen an die Abschirmung, die Abblockung und die Isolationsstufen gegenüber den bekannten Lösungen aus den Figuren 2 und 3 erheblich.

Der größte Nachteil dieses Sendemischkonzeptes besteht im hierfür notwendigen großen technischen Aufwand, da zusätzlich eine Sendemischstufe, ein Oszillator einschließlich eine PLL-Schaltung zur Frequenzstabilisierung und ein Bandfilter benötigt werden. Alleine auf Grund der zusätzlich benötigten elektronischen Komponenten ergibt sich hierfür ein intensiver Kostennachteil gegenüber den beiden vorhergehenden Lösungen.

Ein weiterer Nachteil dieses aufwendigeren Sendemischkonzeptes besteht darin, daß auf Grund der Anzahl der zusätzlichen elektronischen Komponenten die Baugröße einer solchen Schaltungsanordnung zu groß ausfällt.

Beim Sendemischkonzept erweist es sich als besonders problematisch, einen hohen Integrationsgrad zu erreichen, da sich Filter und Oszillatoren beziehungsweise Oszillatorspulen beim heutigen Stand der Technik nur sehr schlecht in integrierten Schaltungen unterbringen lassen, beziehungsweise sehr viel Chip-Fläche benötigen. Außerdem lassen sich häufig die für die PLL-Regelschleife benötigten Kondensatoren und Widerstände nicht mit ausreichender Güte integrieren, so daß sie als externe Komponenten anzuordnen sind.

Da bei dem bekannten Sendemischkonzept insgesamt zwei Oszillatoren zur Frequenzstabilisierung, zwei PLL-Regelschleifen einschließlich zwei externer Schleifenfilter nötig sind, und insbesondere Oszillatoren niedriger Frequenz besonders viel Chip-Fläche benötigen oder schlechte Eigenschaften bezüglich des Phasenrauschens aufweisen, erweist sich dieses Sendemischkonzept als relativ ungeeignet für eine hohe Integrationsdichte.

Aus der US 5,179,359 ist ein digital gesteuerter Frequenzgenerator bekannt, der eine erste Oszillatorschaltung zur Erzeugung einer festen Oszillatorfrequenz, die in einem Teiler geteilt durch den Faktor "4" einer Mischstufe zugeführt wird, und einer zweiten Oszillatorschaltung zur Erzeugung eines in der Frequenz steuerbaren Niedrigfrequenzsignals, das über ein Paar geschalteter Kapazitätsfilter ebenfalls der Mischstufe zugeführt wird, besteht. Bei dem so aufgebauten Frequenzgenerator wird mit Hilfe der beiden Oszillatorschaltungen am Ausgang der Mischstufe eine von einem digitalen Steuerwort abhängige, also einstellbare Ausgangsfrequenz für ein Radarverfolgungssystem erzeugt. Mit dem bekannten digital steuerbaren Frequenzgenerator wird einerseits das bei herkömmlichen spannungsgesteuerten Oszillatoren (Voltage Control Oscillator; VCO) durch die analoge Signalsteuerung regelmäßig auftretende und insbesondere in der Radartechnik unerwünschte Phasenrauschen und andererseits der bei digital kontrollierten Oszillatorsignalen, die mittels der direkten digitalen Synthese (Direct Digital Synthesis; DDS) erzeugt werden, auftretende und insbesondere in der Radartechnik unerwünschte Effekt, dass aufgrund der spektralen Reinheit des Ausgangssignals mehrere Frequenzen statt - wie gewünscht - einer einzigen Frequenz erzeugt werden, vermieden.

Aus der US 4,105,949 ist ein Frequenzsynthesizer bekannt, bei dem aus einer von einem Referenzgenerator, der nicht steuerbar ist, erzeugten festen Oszillatorfrequenz ein Ausgangssignal mit einer variablen Ausgangsfrequenz basierend auf dem Prinzip der direkten Synthese erzeugt wird. Um diese variable Ausgangsfrequenz zu erzeugen, werden das von dem nicht steuerbaren Referenzgenerator erzeugte Referenzgeneratorsignal mit einer festen Signalfrequenz einerseits zunächst einer Teilerschaltung mit einem Faktor N zugeführt, bevor im Anschluss daran die mit dem Faktor N geteilte Signalfrequenz einem ersten harmonischen Generator zur Erzeugung von harmonischen Frequenzanteilen des geteilten Referenzgeneratorsignals zugeführt wird, bevor im Anschluss daran das in dem harmonischen Generator verarbeitete geteilte Referenzgeneratorsignal einem ersten SAW-Filter zur Erzeugung einer Anzahl N von diskreten Signalen, von denen anschließend in einer ersten Selektionsschaltung eins dieser diskreten Signale selektiert wird und bevor zum Abschluss das selektierte diskrete Signal einem Mischer zugeführt wird sowie andererseits unmittelbar einem zweiten harmonischen Generator zur Erzeugung von harmonischen Frequenzanteilen des Referenzgeneratorsignals zugeführt, bevor danach das in dem zweiten harmonischen Generator bearbeitete Referenzgeneratorsignal einem zweiten SAW-Filter zur Erzeugung einer Anzahl N diskreter Signale, von denen anschließend wieder in einer zweiten Selektionsschaltung ein einziges diskretes Signal selektiert wird und bevor zum Abschluss auch dieses selektierte diskrete Signal dem Mischer zugeführt wird und die beiden in dem Mischer gemischten diskreten Signale in einem Bandpassfilter gefiltert.

Es ist daher Aufgabe der Erfindung eine elektronische Schaltungsanordnung zur Erzeugung einer Sendefrequenz anzugeben, welche einerseits die günstigen technischen Voraussetzungen des Sendemischkonzeptes bietet und andererseits die Schaffung einer hohen Integrationsdichte der Schaltung und damit eine kostengünstige Herstellung ermöglicht.

Die Aufgabe wird durch die Merkmale des Anspruches 1 gelöst.

Demgemäß wird eine elektronische Schaltungsanordnung zur Erzeugung einer Sendefrequenz $f_s$ für einen Sender/Empfänger vorgeschlagen, welche die folgenden Bauteile enthält: Einen steuerbaren Oszillator zur Erzeugung einer Oszillatorfrequenz $f_{osz}$, einen Teiler durch einen Faktor N und eine Mischstufe mit einem nachfolgenden Bandfilter, wobei die Bauteile derart miteinander verbunden sind, daß die von dem steuerbaren Oszillator erzeugte Oszillatorfrequenz $f_{osz}$ und eine von dem Teiler durch den Faktor N geteilte Oszillatorfrequenz $f_{osz}/N$ dem Mischer als Eingangssignale zugeführt und von diesem als Sendefrequenz $f_s$ ausgegeben werden.

Ein wesentlicher Vorteil dieser Anordnung darin, daß sich mit der erfindungsgemäßen Schaltungsanordnung ein geringeres Phasenrauschen ergibt, als dies mit den zwei Oszillatoren des bekannten Sendemischkonzeptes erreichbar wäre, da nur ein einziger Oszillator zum Phasenrauschen beitragen kann.

Eine Vereinfachung des Aufbaues der Schaltung wird dadurch erreicht, daß anstelle der Mischstufe mit nachfolgendem Bandfilter ein Einseitenbandmischer (= Image Reject Mixer) verwendet wird. Einseitenbandmischer sind als fertige Bauteile erhältlich und kompakt in den Schaltungsaufbau integrierbar.

Eine weitere vorteilhafte Ausgestaltung der erfindungsgemäßen elektronischen Schaltungsanordnung kann darin bestehen, daß ein PLL-Schaltkreis zur Stabilisierung verwendet wird, welchem als Eingangssignale eine Referenzfrequenz und entweder die Oszillatorfrequenz oder die Ausgangsfrequenz des Bandfilters oder gegebenenfalls des Einseitenbandmischers zugeführt werden.

Weiterhin kann es vorteilhaft sein, wenn der Faktor N des Teilers ein Vielfaches der Zahl der 2 und/ oder größer als 1 ist und zwei um 90° zueinander phasenverschobene Ausgangssignale liefert.

Die gewünschte Phasenverschiebung um 90° kann erreicht werden, durch die Pasenverschiebung eines Teils des Signals um 90° und Beibehaltung der ursprünglichen Phase für das restliche Teilsignal, oder durch die Phasenverschiebung beider Teilsignale um jeweils +45° und -45°. In beiden Fällen bleibt eine Phasendifferenz von 90°.

Eine weitere vorteilhafte Ausgestaltung der erfindungsgemäßen elektronischen Schaltungsanordnung kann darin bestehen, daß zusätzlich eine Steuervorrichtung vorgesehen ist, die zum Zeitpunkt des Einschaltens einer am Ausgang des Einseitenbandmischers angeschlossenen Sende-Endstufe einem Oszillator-Steuersignal ein Datensignal zu Erzeugung einer Frequenzmodulation überlagert. Eine derartige Steuervorrichtung wird beispielsweise in sogenannten TDMA-Systemen verwendet.

Im Hinblick auf eine optimale Integration und einfache Realisierung der Schaltung ist es weiterhin vorteilhaft, die Steuervorrichtung mit Hilfe eines ASIC-Bauteils zu verwirklichen.

Eine andere vorteilhafte Ausgestaltung der Schaltungsanordnung sieht vor, daß die Steuervorrichtung zwei Schalter im Wechsel betätigt, die eine Verbindung des Oszillatorsteuereingangs, entweder zu einem Datenmodulator oder zwecks Kanaleinstellung zum PLL freigibt.

Weiterhin kann eine alternative Ausgestaltung der erfindungsgemäßen elektronischen Schaltungsanordnung darin bestehen, daß ein Überlagerungsempfänger vorgesehen ist, welcher eine Überlagerungsfrequenz direkt aus der Oszillatorfrequenz $f_{osz}$ bezieht, und daß eine Umschaltvorrichtung vorgesehen ist, die im Sendefall die Einseitenbandmischer-Ausgangsfrequenz und im Empfangsfall die Oszillatorfrequenz dem PLL-Regelkreis zuführt.

Vorteilhaft kann der Oszillator beispielsweise spannungsgesteuert oder stromgesteuert betrieben und gegebenenfalls kann auch eine Referenzfrequenz extern zugeführt werden.

Es versteht sich, daß die vorstehend genannten zu erläuternden Merkmalen der Erfindung nicht nur in der jeweils angegebenen Kombination, sondern auch in anderen Kombinationen oder in Alleinstellung verwendbar sind, ohne den Rahmen der Erfindung zu verlassen.

Weitere Merkmale und Vorteile der Erfindung ergeben sich aus der nachfolgenden Beschreibung bevorzugter Ausführungsbeispiele unter Bezugnahme auf die Zeichnungen.

Die Erfindung soll nachfolgend anhand der Zeichnungen näher erläutert werden. Es stellen im Einzelnen dar:

Fig. 1-4: Schaltungsanordnungen aus dem Stand der Technik;

Fig. 5: Schaltungsanordnung mit Mischer und nachfolgendem Bandfilter;

Fig. 6: Schaltungsanordnung mit Einseitenbandmischer;

Fig. 7 - 10: Schaltungsanordnungen mit verschiedenen Modulator-Anodnungen;

Figur 11: Schaltungsanordnung mit Superhet-Empfänger und Nutzung des Oszillators auf der Empfängerseite;

Figur 12: Schaltungsanordnung mit Einseitenbandmischer und Superhet-Empfänger mit einem Sende/Empfangs-Bandfilter;

Figur 13: Schaltungsanordnung mit Einseitenbandmischer und TDMA-Steuervorrichtung.

Die Figur 1 zeigt eine bekannte Schaltungsanordnung für ein TDMA-Funksystem mit einem Oszillator 2 und einer PLL-Schaltung 1 zur Erzeugung einer möglichst stabilen Frequenz, einer TDMA-Steuerung 3 eines Sendeverstärkers 4 und einer Antenne 5.

Bei dieser Schaltungsanordnung wird im Moment des Einschaltens des Sendeverstärkers 4 die Frequenzerzeugung über Lastwechsel und/oder Rückwirkungen - angedeutet durch die Pfeile 6 und 7 - gestört und ein unerwünschter Frequenzsprung erzeugt. Der Lastwechsel entsteht beim Einschalten des Sendeverstärkers 4 durch die Änderung seiner Eingangsimpedanz.

Rückwirkungen auf die Frequenzerzeugung entstehen über die Einstrahlung von der Antenne 5, oder durch andere, hier nicht dargestellte Verkopplungspfade zwischen der Sende-Endstufe und der Frequenzerzeugung. Ein Beispiel hierfür stellen die Versorgungsspannungszuleitungen dar.

Die Figur 2 zeigt eine bekannte Schaltung zur Vermeidung des Frequenzsprunges. Die Schaltung enthält zusätzlich zu den in Figur 1 dargestellten Komponenten die Dämpfungsglieder 8, 9 und eine oder mehrere weitere Verstärkerstufen zur Verringerung des für die Frequenzerzeugung sichtbaren Lastwechsels. Eine zusätzlich Abschirmung (Faradayscher Käfig) 12 der Frequenzerzeugung zur Verminderung von Einstrahlung ist ebenso dargestellt. Weiterhin ist meist eine - hier nicht dargestellte - Hochfrequenzabblockung der in die Abschirmung führenden Leitungen vorhanden.

Die Figur 3 zeigt eine weitere bekannte Variante einer Schaltung zur Frequenzerzeugung mit einer Frequenzvervielfacherstufe oder Teilerstufe 13. Bei diesem Beispiel schwingt der Oszillator 2 auf einer Harmonischen oder Subharmonischen der gewünschten Sendefrequenz, wodurch sich entsprechend dem Vervielfachungsgrad oder Teilungsgrad sowohl eine geringere Lastabhängigkeit als auch eine geringere Empfindlichkeit gegen elektromagnetische Einstrahlungen ergibt.

Die beste bekannte Schaltung mit der wirkungsvollsten Unterdrückung von Rückkopplungen und Frequenzsprüngen beim Einschalten des Sendeverstärkers ist in der Figur 4 dargestellt. Diese Figur 4 zeigt eine Schaltungsanordnung zur Erzeugung einer Sendefrequenz unter Verwendung eines Sendemischkonzeptes. Hierbei wird die Frequenz des ersten Oszillators 2 und dem ersten PLL-Schaltkreis 1 und die zweite Frequenz des zweiten Oszillators 2 und dem zweiten PLL-Schaltkreis 15 in der Mischstufe 16 gemischt und die gewünschte Frequenz aus den Mischprodukten über das Bandfilter 17 herausgesiebt.

Werden die Frequenzen der Oszillatoren 2 und 14 so gewählt, daß sie ein nichtharmonisches Verhältnis zur gewünschten Frequenz haben, ergibt sich ein hohes Maß an Immunität gegen Lastwechsel - also beim Einschalten des Sendeverstärkers -und Rückwirkungen. Hierdurch verringern sich die Anforderungen an Abschirmung, Abblockung und Isolationsstufen gegenüber den Schaltungsanordnungen aus den Figuren 2 und 3 erheblich. Nachteilig ist der schaltungstechnische Aufwand, da zusätzlich eine Mischstufe 16, ein Oszillator 14 und ein PLL-Schaltkreis 15 zur Frequenzstabilisierung und ein Bandfilter 17 benötigt werden.

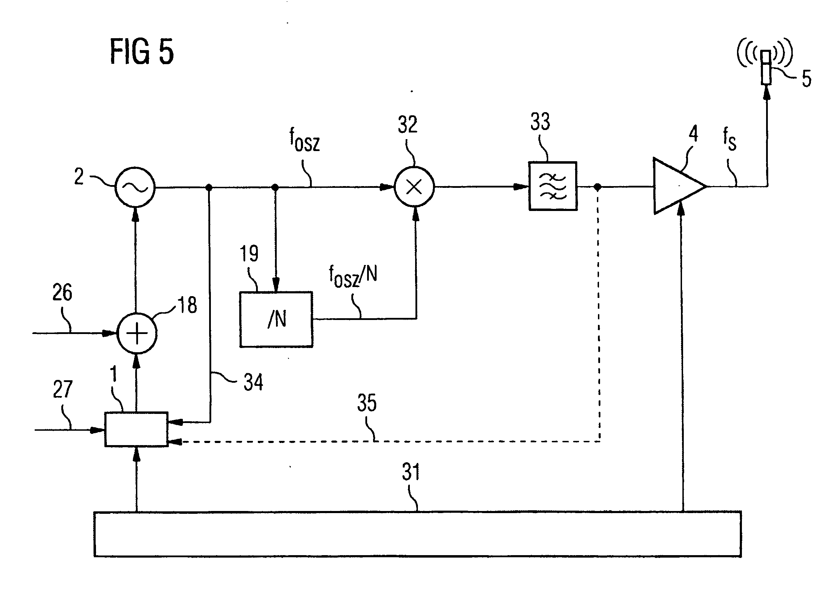

Die Figur 5 zeigt eine einfache erfindungsgemäße Schaltungsanordnung für ein Funksystem, bei dem ein hoher Grad an Kosteneinsparung durch einen guten Integrationsgrad erreicht werden kann. Als Ausgangspunkt wurde das Sendemischkonzept gewählt, jedoch auf den zweiten Oszillator verzichtet.

Die Schaltungsanordnung besteht auf der Eingangseite aus einem einzigen Oszillator 2, der über einem PLL-Schaltkreis 1 stabilisiert wird. Zwischen dem Oszillator 2 und dem PLL-Schaltkreis 1 ist eine Summationsstufe 18 angeordnet, durch welche ein FM-Modulationssignal 26 eingespeist werden kann. Die Frequenz $f_{osz}$ des Oszillators 2 wird zu einem Frequenzteiler 19 geführt und die Frequenz $f_{osz}/N$ erzeugt. Beide Frequenzen $f_{osz}$ und $f_{osz}/N$ gelangen danach zur Bildung der Sendefrequenz $f_s$ zu einem Mischer 32. Im nachfolgenden Bandfilter 22 werden die ebenfalls entstandenen und unerwünschten Nebenfrequenzen ausgefiltert und die gefilterte Frequenz zur Verstärkerendstufe 4 geleitet. Wahlweise kann dem PLL-Schaltkreis 1 entweder die Oszillatorfrequenz $f_{osz}$ über die Leitung 34 oder die Sendefrequenz $f_s$ vom Ausgang des Bandfilters 33 zurückgeführt werden.

Die gewünschte Sendefrequenz $f_s$ ergibt sich damit zu:

$$f_s = f_{osz} \pm \left( \frac{f_{osz}}{N} \right) = f_{osz} * \left( 1 \pm \frac{1}{N} \right)$$

mit    fs=Sendefrequenz,    $f_{osz}$=Oszillatorfrequenz, N=Teilerfaktor

Wie man der mathematischen Beziehung entnehmen kann, ergibt sich ein nicht ganzzahliges Verhältnis zwischen der Sendefrequenz $f_s$ und der Oszillatorfrequenz $f_{osz}$, was eine gute Immunität bezüglich Rückwirkungen verspricht. Die Vorzeichenwahl in der Formel wird durch die Beschaltung des Einseitenbandmischers bestimmt. Man hat die Freiheit, den Oszillator wahlweise unterhalb oder oberhalb der gewünschten Frequenz schwingen zu lassen. Grundsätzlich kann man die Oszillatorfrequenz $f_{osz}$ auch so wählen, daß die Oszillatorfrequenz $f_{osz}$ das Kriterium des technologiebedingten besten Phasenrauschens (beste Güte der Spule) erfüllt.

Zusätzlich zur erfindungsgemäßen Schaltungsanordnung zur Erzeugung der Sendefrequenz ist in der Figur 5 auch eine an sich bekannte TDMA-Steuerung 31 dargestellt, für die sich die erfindungsgemäße Schaltungsanordnung zur Frequenzerzeugung besonders eignet.

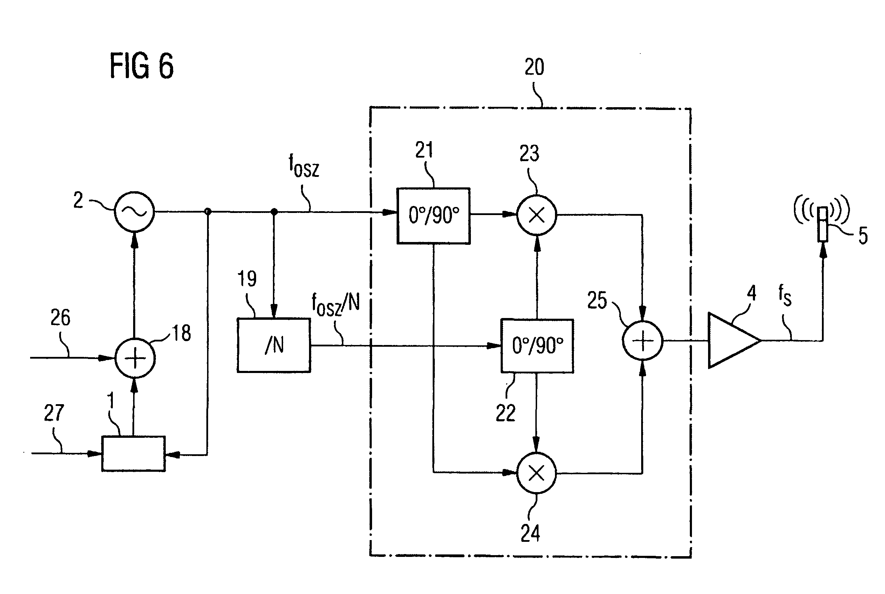

Die Figur 6 zeigt eine Weiterentwicklung der erfindungsgemäßen Schaltungsanordnung aus der Figur 5.

Bei dieser Weiterentwicklung wurde anstelle des Mischers 32 und des nachfolgenden Bandfilters 33 ein Einseitenbandmischer (=Image-Reject-Mixer) 20 verwendet. Wenn die Betriebsbedingungen es erfordern, kann hinter dem Teiler 19 auch noch ein Filterelement zur Unterdrückung der Harmonischen des geteilten Signals eingesetzt werden (nicht dargestellt).

Der Einseitenbandmischer 20 weist typischerweise einen ersten Phasenschieber 21 zur Phasenverschiebung und Teilung der eingehenden Oszillatorfrequenz $f_{osz}$ und einen zweiten Phasenschieber 22 zur Phasenverschiebung der eingehenden geteilten Oszillatorfrequenz $f_{osz}/N$ um jeweils 90°auf. Diese jeweils um 90° phasenverschobenen Frequenzen werden in den Mischern 23 und 24 gemischt, in der Summationsstufe 25 überlagert und als gewünschte Sendefrequenz $f_s$ ausgegeben.

Es ist zu bemerken, daß der Zweck der hier dargestellten Phasenverschiebung von 0° und 90° auch durch eine Phasenverschiebung um -45° und +45° erreicht werden kann.

Auch hier und in allen weiteren Beispielen ergibt sich die gewünschte Sendefrequenz $f_s$ nach der gleichen, zu Figur 5 beschriebenen Formel.

Da sich Frequenzteiler und Einseitenbandmischer mit den heutigen Technologien problemlos integrieren lassen, führt diese Schaltungsanordnung zu einer erheblichen Chip-Flächen-Ersparnis. Weiterhin spart man eine PLL-Regelschleife mit den damit verbundenen externen Komponenten des Schleifen-Filters (engl. "loop-filter").

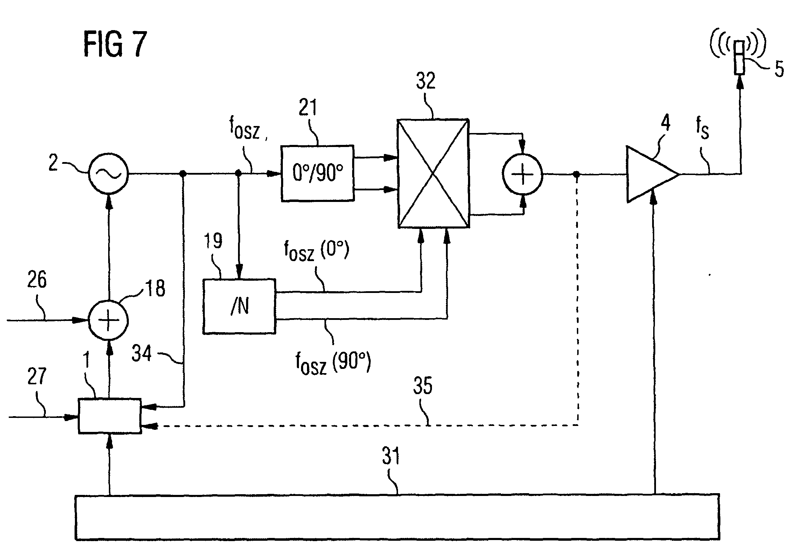

Eine andere erfindungsgemäße Schaltungsanordnung zur Erzeugung einer Sendefrequenz ist in der Figur 7 dargestellt. Hier wird die Oszillatorfrequenz $f_{osz}$ einerseits einem Teiler 19 zugeführt und andererseits einem Phasenschieber 36 zugeführt. Durch die Verwendung eines durch 2 teilbaren Faktors N läßt sich die für das Prinzip der Einseitenbandmischung benötigte Phasenverschiebung von 90° vorteilhaft einfach und präzise erzeugen, wodurch sich eine bessere Unterdrückung des unerwünschten Seitenbandes aus dem Mischprozeß ergibt.

Die um 90° verschobenen Ausgangssignale erhält man in allgemein bekannter Weise, indem die letzte Teilerstufe einer Teilerkette doppelt ausführt, wobei eine der beiden Teilerstufen das Eingangssignal invertiert zugeführt wird.

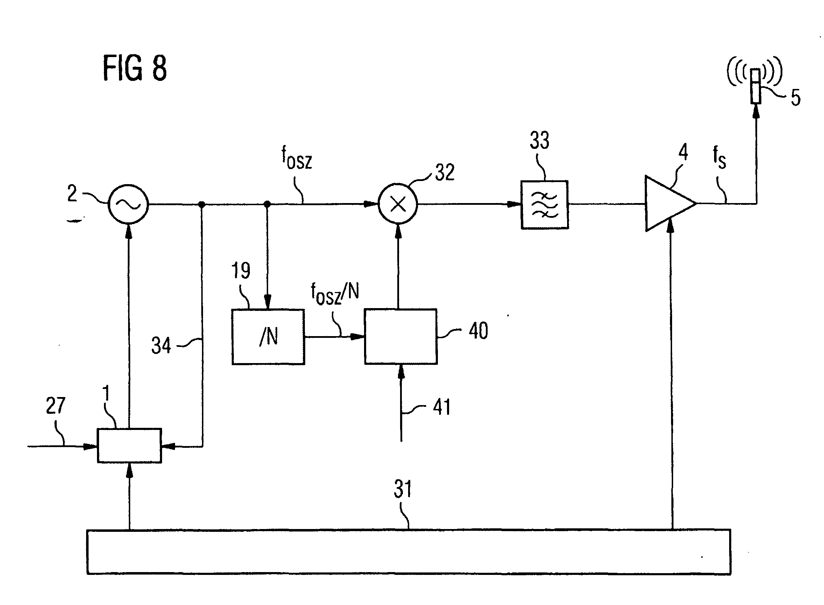

Die Figur 8 zeigt eine Variante der einfachen erfindungsgemäßen Ausführungsform der Schaltungsanordnung aus Figur 5 mit einem Mischer 33 und nachgeschaltetem Bandfilter 33. Der Unterschied zur Figur 5 besteht darin, daß hier ein Modulationssignal 41 einem zwischen Teiler 19 und Mischer 32 angeordneten Modulator 40 aufgegeben wird. Dieser Modulator 40 kann beispielsweise als Vektormodulator ausgeführt sein. Der vereinfacht dargestellte Mischer 32 enthält in der Praxis zwei einzelne Mischer, wobei jeder für ein Signal zuständig ist.

Eine derartige Ausführungsform hat den Vorteil, daß sich beliebige, auch mehrwertige Modulationsarten mit guter Frequenz- bzw Phasenstabilität erzeugen lassen.

Das zugeführte Modulationssignal 4 kann beispielsweise das von einem digitalen Signalprozessor erzeugte IQ-Basisband einer GMSK-, N-PSK-, oder Quadraturamplitudenmodulation sein.

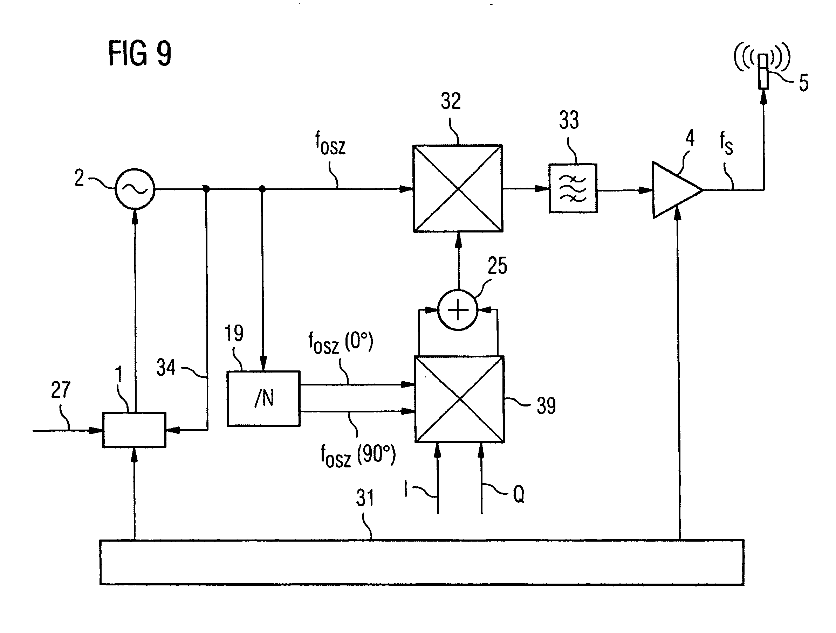

Eine andere Modifikation der erfindungsgemäßen Schaltungsanordnung ist in der Figur 9 dargestellt. Diese entspricht im wesentlichen der Figur 5, jedoch werden hier zur Erzeugung und Modulation der Sendefrequenz zwei um 90° phasenversetzte und durch N geteilte Frequenzen $f_{osz}(0°)$ und $f_{osz}(90°)$ einer Mischstufe 39 zugeführt, die gleichzeitig als Modulator arbeitet, indem sie die Datensignale einer Basisbandaufbereitung I und Q einmischt. Anschließend werden die Ausgangssignale zur Summationsstufe 25 geleitet und zum Mischer 32 geführt. Hier ergibt sich der Vorteil aus der präzise erzeugten 0°/90° Phasenverschiebung aus dem Teiler N, welche vom IQ-Modulator benötigt wird.

Im Mischer 32 wird wiederum durch Mischen mit der Oszillatorfrequenz $f_{osz}$ die Sendefrequenz $f_s$ einschließlich Nebenfrequenzen erzeugt, die Nebenfrequenzen weitgehend beim Durchgang durch das nachfolgende Bandfilter 33 herausgefiltert und die verbleibenden Sendefrequenz $f_s$ zum Sendeverstärker 4 geleitet und über die Antenne 5 abgestrahlt. Ebenso wie in der Figur 5 ist zusätzlich die optionale TDMA-Steuerung 31 dargestellt.

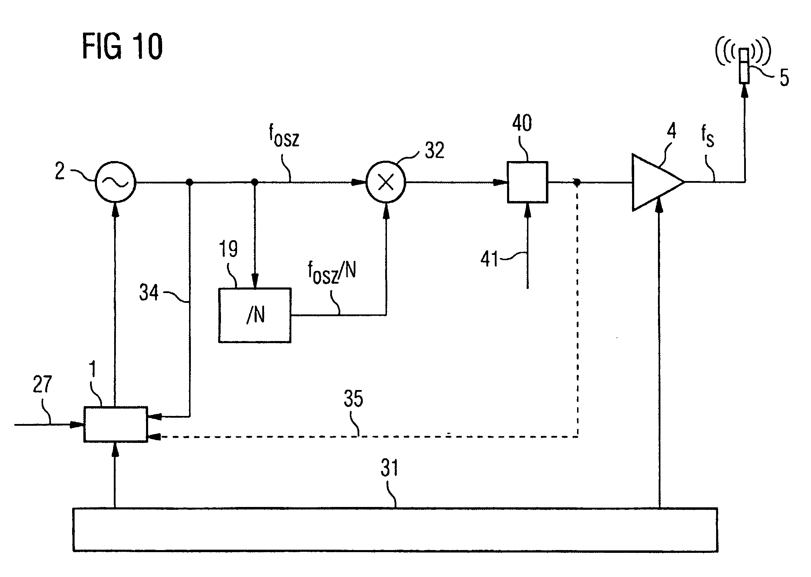

Eine weitere Möglichkeit eine Modulation auf das Sendesignal zu übertragen, ist in der Figur 10 dargestellt. Die Schaltungsanordnung entspricht auch hier der einfachen Ausführung aus der Figur 5, jedoch wird eine Modulation nicht der Oszillatorfrequenz überlagert, sondern es ist anstelle des Bandfilters 33 hinter dem Mischer 32 ein Modulator 40 nachgeordnet, dem ein Modulationssignal 41 von einem Basisband zugeführt wird. Es handelt sich also um eine "Kombination" der Ausführung mit einem IQ-Modulator, mit welchem sich wie bei Figur 8 und 9 dargestellt beliebige Modulationsarten verwirklichen lassen.

Die Figuren 5 bis 10 zeigen somit unterschiedlichste Möglichkeiten der Modulation einer erfindungsgemäß erzeugten Sendefrequenz $f_s$ durch unterschiedlichen Modulationsarten wie beispielsweise GMSK (=gausian minimum shift keying), nPSK (= n-faches phase shift keying) oder QAM (=quadratur amplitude modulation).

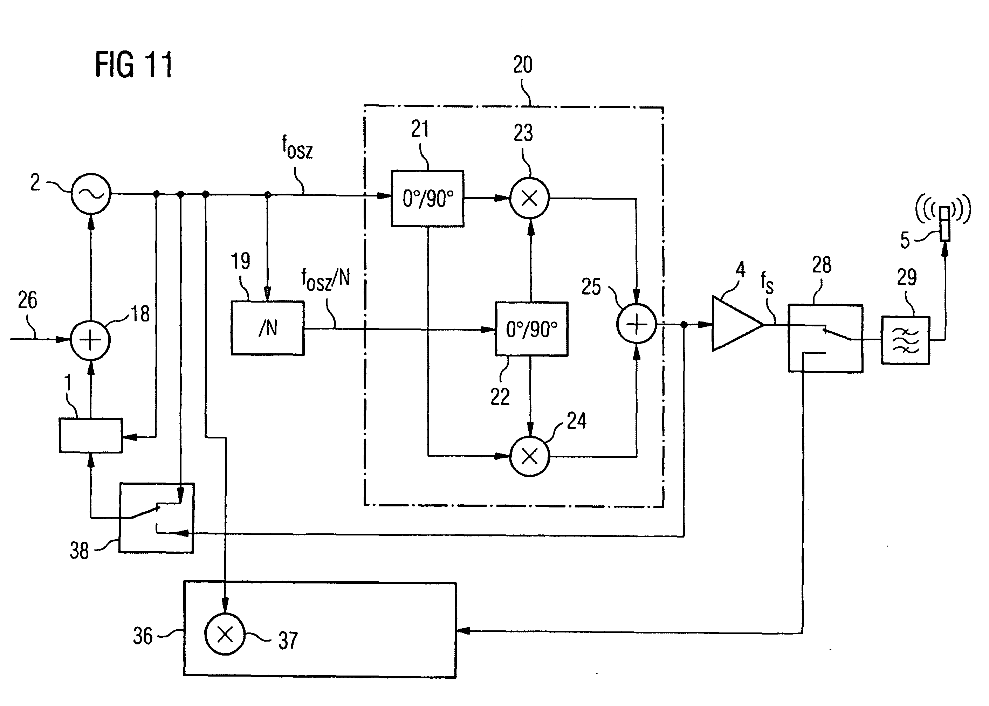

In der Figur 11 ist eine weitere Schaltungsanordnung gezeigt, die eine Kombination der Frequenzerzeugung mit einem Superhet-Empfänger darstellt und weitere Vorteile bietet. Der Grundaufbau der Schaltung entspricht der Schaltungsanordnung aus der Figur 6, jedoch ist zusätzlich ein Überlagerungsempfänger 36 mit integriertem Empfangsmischer 37 und dem zusätzlichen Umschalter 38, welcher die gleiche PLL-Schrittweite im Sende- und Empfangsbetrieb ermöglicht.

Im Empfangsbetrieb erzeugt der Oszillator 2 das Überlagerungssignal, während der gleiche Oszillator 2 im Sendefall zur Erzeugung der Sendefrequenz verwendet wird. Die Zwischenfrequenz im Empfangsfall wählt man derart, daß sie in der Nähe der Oszillator-Offset-Frequenz im Sendefall liegt. Zwar ist der Abstimmbereich des Empfängers entsprechend dem Offset zwischen Sendefrequenz und Oszillatorfrequenz etwas kleiner, was sich in der Praxis mit größeren Teilerfaktoren aber kaum auswirkt. Die Ankopplung der PLL-Regelschleife erfolgt über den Umschalter 38 im Sendefall nach dem Einseitenbandmischer 20 und im Empfangsfall direkt vom Oszillator 2, um eine einheitliche Abstimmschrittweite der PLL mit derselben Referenzfrequenz zu ermöglichen. Vorteilhaft ist hierbei, daß nur ein einziger Oszillator 2 für den Sendebetrieb und den Empfangsbetrieb nötig ist und gleichzeitig eine gute Stabilität der Sendefrequenz im TDMA-Betrieb erreicht wird.

Dieser gezeigte Schaltungsaufbau eignet sich besonders für DECT-Systeme.

Ein Nachteil, den die erfindungsgemäße Schaltungsanordnung gegenüber einem auf der Endfrequenz arbeitendem Oszillator hat, nämlich die zusätzlichen unerwünschten Mischprodukte eines realen Einseitenbandmischers, lassen sich durch ein Hinzufügen eines im Empfänger ohnehin notwendigen Hochfrequenzfilters vor dem Sende/Empfangs-Umschalter entschärfen. In diesem Fall wird das Filter sowohl für den Sendezweig als auch für den Empfangszweig verwendet.

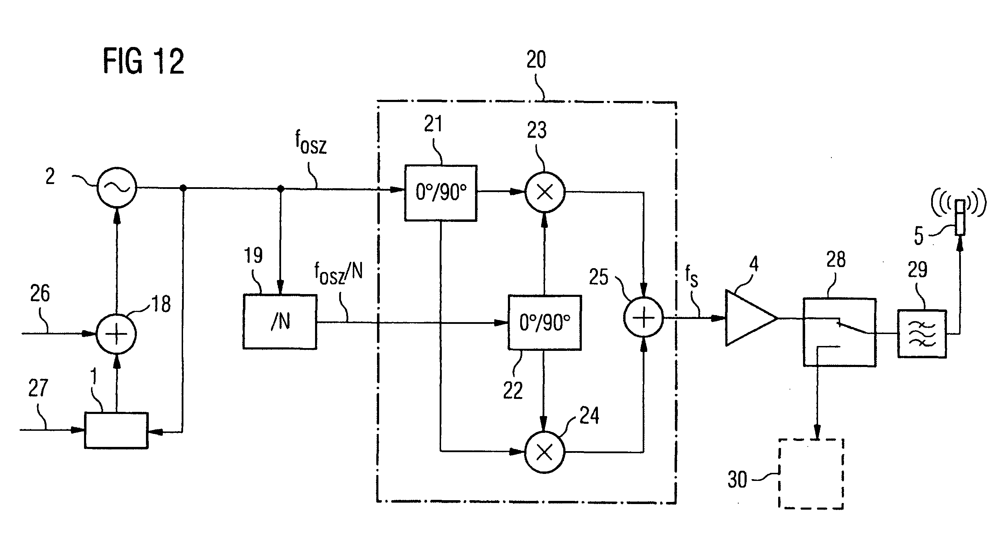

Eine derartige Lösung ist beispielhaft in der Figur 12 dargestellt, welche bis zum Sendeverstärker 4 der Schaltungsanordnung aus der Figur 6 entspricht. Anschließend ist Sende/Empfangs-Umschalter 28 angeordnet, der zwischen dem Sendeverstärker 4 und dem - gestrichelt angedeuteten - Empfänger 30 umschaltet. Zwischen der Antenne 5 und dem Sende/Empfangs-Umschalter 28 ist der erwähnte Hochfrequenzfilter 29 geschaltet.

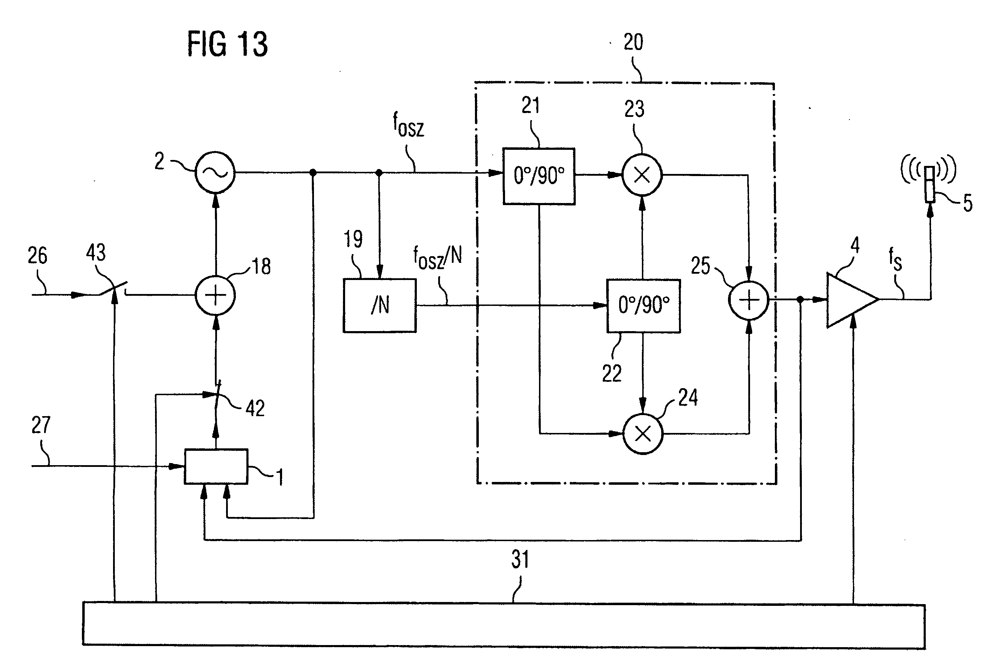

Schließlich zeigt die Figur 13 noch eine erfindungsgemäße Schaltungsanordnung mit einem Einseitenbandmischer 20, wie sie in der Figur 6 beschrieben ist. In diesem Fall wird durch die TDMA-Steuerung 31 jedoch erreicht, daß zum Zeitpunkt des Einschaltens der Sende-Endstufe dem Oszillator-Steuersignal ein Datensignal zur Erzeugung einer Frequenzmodulation überlagert wird.

Dies ist eine Anordnung, wie sie beispielsweise in einem DECT-System mit "Open-loop-Modulationsverfahren" eingesetzt wird. Bei geschlossenem Schalter 42 wird während eines nicht für den Sende-Empfangsbetrieb benötigten Zeitschlitzes der Oszillator 2 über die PLL-Schaltung 1 auf den gewünschten Kanal eingestellt. Kurz vor Sendebeginn öffnet der Schalter 42 und die bis dahin gewonnene Regelgröße wird in einem, in der Figur nicht gesondert dargestelltem, Speicherelement gespeichert. Über den Schalter 43 wird während der Aussendung der gespeicherten Regelgröße ein Basisbandsignal zur Erzeugung der DECT-GFSK-Modulation (Gaussian-frequency-shift-keying) überlagert. Durch die erfindungsgemäße Anordnung von Teiler und Mischer beziehungsweise Einseitenbandmischer wird die erforderliche Frequenzstabilität während der Aussendung ermöglicht. D.h. hochfrequente Rückwirkungen von der Sendestufe auf den Oszillator 2 bewirken keinen Frequenzversatz nach Einschalten des Senders.

Insgesamt wird also durch die erfindungsgemäßen Schaltungsanordnungen erreicht, daß einerseits die günstigen technischen Voraussetzungen des Sendemischkonzeptes genutzt werden können und andererseits eine hohe Integrationsdichte der Schaltung und damit eine kostengünstige Herstellung möglich wird.

**Patentansprüche**

1. Elektronische Schaltungsanordnung zur Erzeugung einer Sendefrequenz für einen Sender/Empfänger mit folgenden Merkmalen: Ein steuerbarer Oszillator (2) zur Erzeugung einer Oszillatorfrequenz ($f_{osz}$), ein Teiler (19) durch einen Faktor N und eine Mischstufe (32) mit einem nachfolgenden Bandfilter (33) sind derart miteinander verbunden, daß die von dem steuerbaren Oszillator (2) erzeugte Oszillatorfrequenz ($f_{osz}$) und eine von dem Teiler (19) durch den Faktor N geteilte Oszillatorfrequenz ($f_{osz}$/N) der Mischstufe (32) als Eingangssignale zugeführt werden.

2. Elektronische Schaltungsanordnung gemäß dem voranstehenden Anspruch 1, **dadurch gekennzeichnet, daß** anstelle der Mischstufe (32) mit nachfolgendem Bandfilter (33) ein, insbesondere als "Image Reject Mixer" ausgebildeter, Einseitenbandmischer (20) vorgesehen ist.

3. Elektronische Schaltungsanordnung gemäß einem der voranstehenden Ansprüche 1 bis 2, **dadurch gekennzeichnet, daß** ein PLL-Schaltkreis (1) zur Stabilisierung der Oszillatorfrequenz ($f_{osz}$) vorgesehen ist, welchem als Eingangssignale eine Referenzfrequenz und entweder die Oszillatorfrequenz ($f_{osz}$) oder die Ausgangsfrequenz des Einseitenbandmischers (20) oder des Bandfilters (33) zugeführt werden.

4. Elektronische Schaltungsanordnung gemäß einem der voranstehenden Ansprüche 1 bis 3, **dadurch gekennzeichnet, daß** der Faktor N des Teilers (19) ein ganzzahliges Vielfaches der Zahl 2 ist und zwei um 90° phasenverschobene Ausgangssignale liefert.

5. Elektronische Schaltungsanordnung gemäß einem der voranstehenden Ansprüche 1 bis 4, **dadurch gekennzeichnet, daß** eine Steuervorrichtung (31) vorgesehen ist, die zum Zeitpunkt des Einschaltens einer am Ausgang der Mischstufe (32) mit dem nachfolgenden Bandfilter (33) oder des Einseitenbandmischers (20) angeschlossenen Sende-Endstufe (4) einem Oszillator-Steuersignal ein Datensignal zur Erzeugung einer Frequenzmodulation überlagert.

6. Elektronische Schaltungsanordnung gemäß dem voranstehenden Anspruch 5, **dadurch gekennzeichnet, daß** die Steuervorrichtung (31) ein ASIC-Bauteil ist.

7. Elektronische Schaltungsanordnung gemäß einem der voranstehenden Ansprüche 5 bis 6, **dadurch gekennzeichnet, daß** die Steuervorrichtung (31) zwei Schalter (42, 43) im Wechsel betätigt, die den Steuereingang des Oszillators (2) zum Zeitpunkt des Einschaltens der Sendestufe vom PLL-Schaltkreis (1) trennt und ein Datensignal zum Zwecke der Frequenzmodulation einspeist.

8. Elektronische Schaltungsanordnung gemäß einem der voranstehenden Ansprüche 1 bis 7, **dadurch gekennzeichnet, daß** ein Überlagerungsempfänger (36) vorgesehen ist, welcher seine Überlagerungsfrequenz direkt aus der Oszillatorfrequenz ($f_{osz}$) bezieht, und daß eine Umschaltvorrichtung (38) vorgesehen ist, die im Sendefall die Ausgangsfrequenz der Mischstufe (32) mit dem nachfolgenden Bandfilter (33) oder des Einseitenbandmischers (20) und im Empfangsfall die Oszillatorfrequenz dem PLL-Schaltkreis (1) zugeführt wird.

9. Elektronische Schaltungsanordnung gemäß einem der voranstehenden Ansprüche 1 bis 8, **dadurch gekennzeichnet, daß** am Ausgang der Mischstufe (32) mit dem nachfolgenden Bandfilter (33) oder des Einseitenbandmischers (20) ein Verstärker (4) vorgesehen ist.

10. Elektronische Schaltungsanordnung gemäß einem der voranstehenden Ansprüche 1 bis 9, **dadurch gekennzeichnet, daß** der Oszillator (2) spannungsgesteuert ist.

**11.** Elektronische Schaltungsanordnung gemäß einem der voranstehenden Ansprüche 1 bis 9, **dadurch gekennzeichnet, daß** der Oszillator (2) stromgesteuert ist.

**12.** Elektronische Schaltungsanordnung gemäß einem der voranstehenden Ansprüche 1 bis 11, **dadurch gekennzeichnet, daß** eine Referenzfrequenz (26) extern zugeführt ist.

**13.** Elektronische Schaltungsanordnung gemäß einem der voranstehenden Ansprüche 1 bis 12, **dadurch gekennzeichnet, daß** zwischen dem Teiler (19) und der Mischstufe (32) oder des Einseitenbandmischers (20) ein Modulator (40, 39), vorzugsweise ein Vektor-Modulator (39), angeordnet ist, mit welchem durch Zuführung eines IQ-Modulationsbasisbandsignals am Ausgang der Mischstufe (32) ein moduliertes Signal zur Verfügung steht.

**14.** Elektronische Schaltungsanordnung gemäß dem voranstehenden Anspruch 13, **dadurch gekennzeichnet, daß** das aus dem Teiler (19) gewonnene, um 0°/90° phasenverschobene Signal mit in die Erzeugung der Vektormodulation des Modulators (39) einbezogen wird.

**15.** Elektronische Schaltungsanordnung gemäß einem der voranstehenden Ansprüche 1 bis 2, **dadurch gekennzeichnet, daß** an deren Ausgang eine Modulationsstufe, vorzugsweise eine Vektor- Modulationsstufe, angeordnet ist, welche eine Modulation des Sendesignals bewirkt.

**Claims**

**1.** Electronic circuit arrangement for generating a transmit frequency for a transceiver having the following features: a controllable oscillator (2) for generating an oscillator frequency ($f_{osz}$), a divider (19) by a factor N and a mixer stage (32) with a subsequent band filter (33) are connected to one another in such a way that the oscillator frequency ($f_{osz}$) which is generated by the controllable oscillator (2) and an oscillator frequency ($f_{osz}/N$) which is divided by the divider (19) by the factor N are fed to the mixer stage (32) as input signals.

**2.** Electronic circuit arrangement according to the preceding Claim 1, **characterized in that**, instead of the mixer stage (32) with subsequent band filter (33), a single-sideband mixer (20) which is embodied in particular as an "Image Reject Mixer" is provided.

**3.** Electronic circuit arrangement according to any of the preceding Claims 1 to 2, **characterized in that** a PLL circuit (1) is provided for stabilizing the oscillator frequency ($f_{osz}$), to which PLL circuit (1) a reference frequency and either the oscillator frequency ($f_{osz}$) or the output frequency of the single-sideband mixer (20) or of the band filter (33) are fed as input signals.

**4.** Electronic circuit arrangement according to one of the preceding Claims 1 to 3, **characterized in that** the factor N of the divider (19) is an integral multiple of the number 2 and supplies two output signals which are phase-shifted by 90°.

**5.** Electronic circuit arrangement according to one of the preceding Claims 1 to 4, **characterized in that** a control device (31) is provided which, at the time of the switching on of a transmit output stage (4) which is connected to the output of the mixer stage (32) with the subsequent band filter (33) or of the single-sideband mixer (20), superimposes on an oscillator control signal a data signal in order to generate a frequency modulation.

**6.** Electronic circuit arrangement according to the preceding Claim 5, **characterized in that** the control device (31) is an ASIC component.

**7.** Electronic circuit arrangement according to one of the preceding Claims 5 to 6, **characterized in that** the control device (31) activates two switches (42, 43) alternately, which disconnects the control input of the oscillator (2) at the time of the switching on of the transmit stage by the PLL circuit (1) and feeds in a data signal for purposes of frequency modulation.

**8.** Electronic circuit arrangement according to one of the preceding Claims 1 to 7, **characterized in that** a superimposition receiver (36) is provided which obtains its superimposition frequency directly from the oscillator frequency ($f_{osz}$), and **in that** a changeover device (38) is provided which in the case of transmission feeds the output frequency to the mixer stage (32) with the subsequent band filter (33) or of the single-sideband mixer (20), and in the case of reception feeds the oscillator frequency to the PLL circuit (1).

**9.** Electronic circuit arrangement according to one of the preceding Claims 1 to 8, **characterized in that** an amplifier (4) is provided at the output of the mixer stage (32) with the subsequent band filter (33) or of the single-sideband mixer (20).

**10.** Electronic circuit arrangement according to one of the preceding Claims 1 to 9, **characterized in that** the oscillator (2) is voltage-controlled.

**11.** Electronic circuit arrangement according to one of the preceding Claims 1 to 9, **characterized in that** the oscillator (2) is current-controlled.

**12.** Electronic circuit arrangement according to one of the preceding Claims 1 to 11, **characterized in that** a reference frequency (26) is supplied externally.

**13.** Electronic circuit arrangement according to one of the preceding Claims 1 to 12, **characterized in that** a modulator (40, 39), preferably a vector modulator (39), with which a modulator signal is made available at the output of the mixer stage (32) by supplying an IQ modulation baseband signal, is arranged between the divider (19) and the mixer stage (32) or of the single-sideband mixer (20).

**14.** Electronic circuit arrangement according to the preceding Claim 13, **characterized in that** the signal which is acquired from the divider (19) and is phase-shifted by 0°/90° is included in the generation of the vector modulation of the modulator (39).

**15.** Electronic circuit arrangement according to one of the preceding Claims 1 to 2, **characterized in that** a modulation stage, preferably a vector modulation stage, which brings about modulation of the transmit signal, is arranged at the output of said electronic circuit.

**Revendications**

**1.** Circuit électronique permettant de produire une fréquence d'émission pour un émetteur /récepteur avec les caractéristiques suivantes: un oscillateur (2) commandable permettant de produire une fréquence oscillateur ($f_{osz}$), un diviseur (19) divisant par un facteur N et un étage de mixage (32) avec un filtre passe-bande (33) en aval sont reliés entre eux de manière telle que la fréquence oscillateur ($f_{osz}$) produite par l'oscillateur (2) commandable et une fréquence oscillateur ($f_{osz}$ / N) divisée par le diviseur (19) par le facteur N sont amenées à l'étage de mixage (32) en tant que signaux d'entrée.

**2.** Circuit électronique selon la revendication 1 précédente, **caractérisé en ce qu'**à la place de l'étage de mixage (32) avec filtre passe-bande (33) en aval est prévu un mélangeur à bande latérale unique (20), configuré plus particulièrement comme «Image Reject Mixer».

**3.** Circuit électronique selon l'une des revendications précédentes 1 à 2, **caractérisé en ce qu'**est prévu un circuit PLL (1) pour stabiliser la fréquence oscillateur ($f_{osz}$), auquel sont amenées, en tant que signaux d'entrée, une fréquence de référence et soit la fréquence oscillateur ($f_{osz}$) soit la fréquence de sortie du mélangeur à bande latérale unique (20) ou du filtre passe-bande (33).

**4.** Circuit électronique selon l'une des revendications précédentes 1 à 3, **caractérisé en ce que** le facteur N du diviseur (19) est un multiple entier du chiffre 2 et **en ce qu'**il fournit des signaux de sortie déphasés de 90 °.

**5.** Circuit électronique selon l'une des revendications précédentes 1 à 4, **caractérisé en ce qu'**est prévu un dispositif de commande (31) qui, au moment de la mise en marche d'un étage final d'émission (4) connecté à la sortie de l'étage de mixage (32) avec le filtre passe-bande (33) en aval ou du mélangeur à bande latérale unique (20), superpose à un signal de commande d'oscillateur un signal de données pour la production d'une modulation de fréquence.

**6.** Circuit électronique selon la revendication précédente 5, **caractérisé en ce que** le dispositif de commande (31) est un composant ASIC.

**7.** Circuit électronique selon l'une des revendications précédentes 5 à 6, **caractérisé en ce que** le dispositif de commande (31) actionne en alternance deux interrupteurs (42, 43), lequel coupe l'entrée de commande de l'oscillateur (2) du circuit PLL (1) au moment de la mise en marche de l'étage d'émission et injecte un signal de données aux fins de la modulation de fréquence.

**8.** Circuit électronique selon l'une des revendications précédentes 1 à 7, **caractérisé en ce qu'**est prévu un récepteur superhétérodyne (36) qui tire sa fréquence hétérodyne directement de la fréquence oscillateur ($f_{osz}$) et **en ce qu'**est prévu un dispositif de commutation (38) qui amène au circuit PLL (1) la fréquence de sortie de l'étage de mixage (32) avec le filtre passe-bande (33) en aval ou du mélangeur à bande latérale unique (20) dans le cas de l'émission et la fréquence oscillateur dans le cas de la réception.

**9.** Circuit électronique selon l'une des revendications précédentes 1 à 8, **caractérisé en ce qu'**est prévu un amplificateur (4) à la sortie de l'étage de mixage (32) avec le filtre passe-bande (33) en aval ou du mélangeur à bande latérale unique (20).

**10.** Circuit électronique selon l'une des revendications précédentes 1 à 9, **caractérisé en ce que** l'oscillateur (2) est commandé par tension.

**11.** Circuit électronique selon l'une des revendications précédentes 1 à 9, **caractérisé en ce que** l'oscillateur (2) est commandé par courant.

**12.** Circuit électronique selon l'une des revendications précédentes 1 à 11, **caractérisé en ce qu'**une fréquence de référence (26) est amenée en externe.

**13.** Circuit électronique selon l'une des revendications précédentes 1 à 12, **caractérisé en ce qu'**est monté, entre le diviseur (19) et l'étage de mixage (32) ou le mélangeur à bande latérale unique (20), un modulateur (40, 39), qui est de préférence un modulateur vectoriel (39), avec lequel un signal modulé est disponible à la sortie de l'étage de mixage (32) par amenée d'un signal bande de base de modulation IQ.

**14.** Circuit électronique selon la revendication 13 précédente, **caractérisé en ce que** le signal déphasé de 0 ° / 90 ° obtenu du diviseur (19) est pris en compte dans la production de la modulation vectorielle du modulateur (39).

**15.** Circuit électronique selon l'une des revendications précédentes 1 à 2, **caractérisé en ce qu'**est situé à sa sortie un étage de modulation, qui est de préférence un étage de modulation vectorielle, lequel provoque une modulation du signal d'émission.

FIG 1    Stand der Technik

FIG 2    Stand der Technik

FIG 3    Stand der Technik

FIG 4    Stand der Technik

FIG 5

EP 1 188 228 B1

# FIG 6

EP 1 188 228 B1

FIG 7

FIG 8

EP 1 188 228 B1

FIG 9

FIG 10

EP 1 188 228 B1

FIG 11

FIG 12

EP 1 188 228 B1

FIG 13

$f_S$

$f_{OSZ}$

$f_{OSZ}/N$

0°/90°

0°/90°

0°/90°

/N